# EUROPEAN PATENT APPLICATION

(11) **EP 4 671 783 A1**
(43) Date of publication of application: **31.12.2025**
(21) Application number: 23934222.3
(22) Date of filing: 07.11.2023
(51) Int. Cl.: G01R 31/367, G01R 31/396, G01R 31/382, G01R 31/385, G01R 31/392, G06N 20/00

(54) **DATA PROCESSING DEVICE AND OPERATION METHOD THEREOF**

(30) Priority: 19.04.2023 KR 20230051510
(71) Applicant: LG ENERGY SOLUTION, LTD., Seoul 07335 (KR)
(72) Inventor: YIM, In Hyeok, Daejeon 34122 (KR); PARK, Ji Hye, Daejeon 34122 (KR); CHOI, Jee Soon, Daejeon 34122 (KR)
(74) Representative: Plasseraud IP
(86) International application number: PCT/KR2023/017750
(87) International publication number: WO 2024/219575

(57) **Abstract**

A data processing apparatus according to an embodiment disclosed in this document may include an acquisition unit configured to acquire experimental data of a battery and field data of a vehicle, a generation unit configured to generate synthetic data based on the experimental data and the field data, and a first learning unit configured to train a denoising model to remove noise from the synthetic data based on the experimental data and the synthetic data.

## Description

### [Technical Field]

### CROSS-REFERENCE TO RELATED APPLICATION

This application claims priority to and the benefit of Korean Patent Application No. 10-2023-0051510 filed in the Korean Intellectual Property Office on April 19, 2023, the entire contents of which are incorporated herein by reference.

### TECHNICAL FIELD

Embodiments disclosed in this document relate to a data processing apparatus and method.

### [Background Art]

Recently, research and development on secondary batteries have been actively conducted. Here, the secondary battery is a rechargeable battery and includes all of the conventional Ni/Cd batteries, Ni/MH batteries, and recent lithium ion batteries. Among the secondary batteries, Lithium ion batteries have an advantage of much higher energy density than the conventional Ni/Cd batteries and Ni/MH batteries. In addition, Lithium-ion batteries can be manufactured small and lightweight enough to be used as power sources for mobile devices and recently expand their usage range to power sources for electric vehicles, attracting attention as a next-generation energy storage medium.

Typically, the state diagnosis of secondary batteries is conducted using experimental data obtained through battery charge-discharge tests. Additionally, machine learning-based state diagnosis models trained with such experimental data are applied to the actual state diagnosis of batteries installed in vehicles.

However, the experimental data from batteries and the field data from batteries installed in vehicles exhibit significantly different characteristics. However, the experimental data from batteries and the field data from batteries installed in vehicles exhibit significantly different characteristics. Therefore, applying the state diagnosis model trained using experimental data to diagnose the state of batteries installed in actual vehicles raises concerns about the reliability of the diagnostic results. To address such issues, a new approach is needed to generate data that reflects the characteristics of field data from batteries.

### [Disclosure]

### [Technical Problem]

The embodiments disclosed in this document provide a data processing apparatus and method capable of generating synthetic data that reflects the characteristics of field data from batteries installed in an actual vehicle to the experimental data of batteries.

The embodiments disclosed in this document provide a data processing apparatus and method capable of removing (or reducing) noise from the synthetic data using a denoising model.

The embodiments disclosed in this document provide a data processing apparatus and method capable of evaluating the performance of the denoising model using the output data of the denoising model and the synthetic data.

The technical objects of the embodiments disclosed in this document are not limited to the aforesaid, and other objects not described herein with be clearly understood by those skilled in the art from the descriptions below.

### [Technical Solution]

According to an embodiment disclosed in this document, the data processing apparatus may include an acquisition unit configured to acquire experimental data of a battery and field data of a vehicle, a generation unit configured to generate synthetic data based on the experimental data and the field data, and a first learning unit configured to train a denoising model to remove noise from the synthetic data based on the experimental data and the synthetic data.

According to an embodiment disclosed in this document, the generation unit may an extraction unit configured to extract noise data from the field data and generate the synthetic data by synthesizing the experimental data and the noise data.

According to an embodiment disclosed in this document, the data processing apparatus may further include a second learning unit configured to train an extraction model extracting the noise data reflecting noise characteristics of the field data based on the experimental data and the field data, wherein the extraction unit may be configured to extract the noise data from the field data based on the extraction model.

According to an embodiment disclosed in this document, the data processing apparatus may further include a filtering unit configured to generate denoised data by removing noise from the synthetic data using the denoising model.

According to an embodiment disclosed in this document, the data processing apparatus may further include a third learning unit configured to generate a first state diagnosis model by training a state diagnosis model diagnosing state of the battery based on the denoised data.

According to an embodiment disclosed in this document, the third learning unit may be configured to generate a second state diagnosis model by training the state diagnosis model based on the synthetic data.

According to an embodiment disclosed in this document, the data processing apparatus may further include an evaluation unit configured to evaluate the performance of the denoising model by comparing the first state diagnosis model and the second state diagnosis model.

According to an embodiment disclosed in this document, the data processing method may include acquiring experimental data of a battery and field data of a vehicle, generating synthetic data based on the experimental data and the field data, and training a denoising model to remove noise from the synthetic data based on the experimental data and the synthetic data.

According to an embodiment disclosed in this document, the generating of the synthetic data may include extracting noise data from the field data and generating the synthetic data by synthesizing the experimental data and the noise data.

According to an embodiment disclosed in this document, the data processing method may further include training an extraction model extracting the noise data reflecting noise characteristics of the field data based on the experimental data and the field data, wherein the noise data may be extracted from the field data based on the extraction model.

According to an embodiment disclosed in this document, the data processing method may further include generating denoised data by removing noise from the synthetic data using the denoising model.

According to an embodiment disclosed in this document, the data processing method may further include generating a first state diagnosis model by training a state diagnosis model diagnosing state of the battery based on the denoised data.

According to an embodiment disclosed in this document, the data processing method may further include generating a second state diagnosis model by training the state diagnosis model based on the synthetic data.

According to an embodiment disclosed in this document, the data processing method may further include evaluating the performance of the denoising model by comparing the first state diagnosis model and the second state diagnosis model.

### [Advantageous Effects]

According to the embodiments disclosed in this document, it is possible to enhance the accuracy of battery diagnostic results using synthetic data generated by reflecting the characteristics of field data from batteries installed in vehicles.

According to the embodiments disclosed in this document, it is possible to improve the performance of the battery state diagnosis model trained using synthetic data by removing (or reducing) the noise in the synthetic data.

In addition, various effects identified directly or indirectly through this document can be provided.

### [Description of Drawings]

FIG. 1 is a block diagram illustrating the configuration of a data processing apparatus according to an embodiment;
FIG. 2 is a block diagram illustrating the configuration of a generation unit of a data processing apparatus according to an embodiment;
FIG. 3 is a diagram illustrating the operations of components in a data processing apparatus according to an embodiment;
FIG. 4 is a flowchart illustrating operations of a data processing apparatus according to an embodiment;
FIG. 5 is a flowchart illustrating operations of a data processing apparatus according to an embodiment;
FIG. 6 is a flowchart illustrating operations of a data processing apparatus according to an embodiment.

### [Mode for Invention]

Hereinafter, various embodiments of the present invention will be described with reference to the accompanying drawings. However, the description is not intended to limit the present invention to particular embodiments, and it should be construed as including various modifications, equivalents, and/or alternatives of the embodiments described herein.

Various embodiments disclosed in this document and terms used therein are not intended to limit the technical features described in this document to specific embodiments, and the disclosure should be construed as including various modifications, equivalents, and/or alternatives of the corresponding embodiments. In connection with the description of the drawings, like reference numbers may be used for like or related elements. The singular form of a noun corresponding to an item may include one item or a plurality of items unless the relevant context clearly dictates otherwise.

In this document, each of the phrases such as "A or B", "at least one of A and B", "at least one of A or B", "A, B or C", "at least one of A, B and C", and "at least one of A, B, or C" may include any of the items listed together in the corresponding phrase or any possible combination thereof. Terms such as "the first", "the second", "first", "second", "A", "B", "(a)", or "(b)" may be used simply to distinguish such components from other components and do not limit the corresponding components in other aspects (e.g., importance or order) unless otherwise stated specifically.

In this document, when it is mentioned that a (e.g., first) component is "connected", "coupled", "accessed", with or without the terms "functionally" or "communicatively", to another (e.g., second) component, it means that the component can be connected to the other component directly (e.g., wired), wirelessly, or via a third component.

According to various embodiments, each component (e.g., module or program) of the components described above may include a single object or a plurality of objects, and some of the multiple objects may be separately disposed in other components. According to various embodiments, one or more components or operations among the aforementioned components may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to various embodiments, operations performed by modules, programs, or other components are executed sequentially, in parallel, iteratively, or heuristically, or one or more of the operations are executed in a different order, omitted, or one or more other operations may be added.

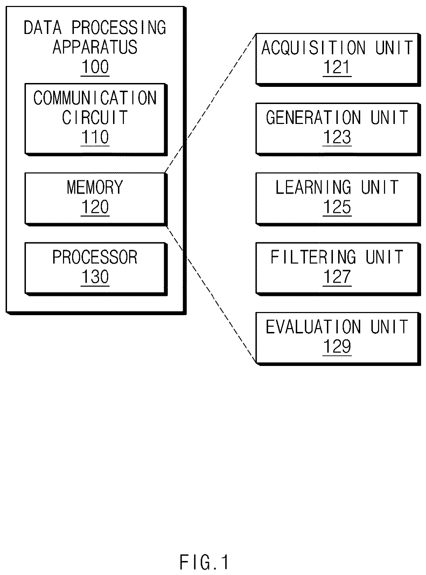

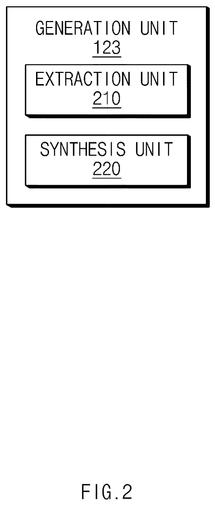

Hereinafter, descriptions are made of the configurations of a data processing apparatus with reference to FIGS. 1 and 2.

FIG. 1 is a block diagram illustrating the configuration of a data processing apparatus according to an embodiment; FIG. 2 is a block diagram illustrating the configuration of a generation unit of a data processing apparatus according to an embodiment;
With reference to FIG. 1, the data processing apparatus 100 may include a communication circuit 110, a memory 120, and/or a processor 130. According to an embodiment, the data processing apparatus shown in FIG. 1 may further include at least one additional component (e.g., a display, input device, or output device) other than the components illustrated in FIG. 1.

According to an embodiment, the communication circuit 110 may establish a wired and/or wireless communication channel between the data processing apparatus 100 and an external electronic device and/or external server and exchange data with the external electronic device and/or external server through the established communication channel. According to an embodiment, the communication circuit 110 may receive experimental data of a battery and/or field data of a vehicle (e.g., an electric vehicle with a secondary battery) from the external electronic device and/or external server. Here, the experimental data may include data related to the state of a battery not installed in a vehicle (voltage, current, temperature, internal resistance, and SOC (State of Charge), and/or SOH (State of Health)). The field data may include data related to the state of the battery installed in the vehicle.

According to an embodiment, the memory 120 may include volatile memory and/or non-volatile memory.

According to an embodiment, the memory 120 may store data used by at least one component of the data processing apparatus 100 (e.g., the processor 130). For example, the data may include software (or related instructions), input data, or output data. In an embodiment, the instructions may be executed by the processor 130 for the data processing apparatus 100 to perform operations defined by the instructions.

According to an embodiment, the memory 120 may include one or more software components (e.g., acquisition unit 121, generation unit 123, learning unit 125, filtering unit 127, and/or evaluation unit 129).

With reference to FIG. 2, the generation unit 123 may include an extraction unit 210 and a synthesis unit 220.

With reference to FIG. 1 again, the processor 130 may include a central processing unit, application processor, graphics processing unit, neural processing unit (NPU), image signal processor, sensor hub processor, or communication processor.

In an embodiment, the processor 130 may execute software (e.g., acquisition unit 121, generation unit 123, learning unit 125, filtering unit 127, and/or evaluation unit 129) to control at least one other component (e.g., hardware or software component) connected to the data processing apparatus 100 and perform various data processing or operations.

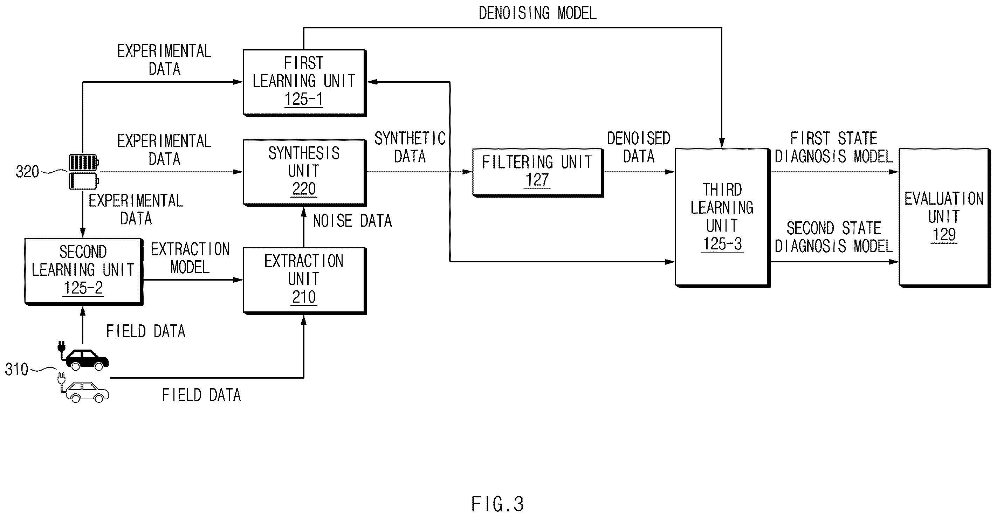

Hereinafter, a description is made of the method of processing for the data processing apparatus 100 to process experimental data of a battery and field data of a vehicle through the acquisition unit 121, generation unit 123, learning unit 125, filtering unit 127, and/or evaluation unit 129, with reference to FIG. 3.

FIG. 3 is a diagram illustrating the operations of components in a data processing apparatus according to an embodiment.

With reference to FIG. 3, the acquisition unit 121 may acquire the field data of the vehicle 310 and the experimental data of the battery 320. Here, the vehicle 310 may be equipped with a battery of the same model as the battery 320, and the field data may include data related to the state of the battery installed in the vehicle 310. According to an embodiment, the acquisition unit 121 may acquire the field data and experimental data from an external electronic device and/or an external server connected via wired and/or wireless networks using the communication circuit 110.

According to an embodiment, the generation unit 123 may generate synthetic data based on the experimental data and field data.

According to an embodiment, the extraction unit 210 included in the generation unit 123 may extract noise data from the field data. According to an embodiment, the extraction unit 210 may extract noise data from the field data based on an extraction model learned by the second learning unit 125-2 or an extraction model stored in the memory 120. Here, the extraction model may be a machine learning-based model that reflects the noise characteristics of field data to extract noise data.

According to an embodiment, the synthesis unit 220 included in the generation unit 123 may synthesize experimental data and noise data to generate synthetic data. According to an embodiment, the generation unit 123 may generate synthetic data by synthesizing random noise (e.g., Gaussian random noise) with the experimental data and noise data.

According to an embodiment, the learning unit 125 may train various machine learning-based learning models based on experimental data, field data, synthetic data, and/or noise removal data.

According to an embodiment, the learning unit 125 may include a first learning unit 125-1, a second learning unit 125-2, and/or a third learning unit 125-3.

According to an embodiment, the first learning unit 125-1 may train a denoising model based on experimental data and synthetic data to remove (or reduce) the noise in synthetic data. The denoising learning model may be a machine learning-based learning model trained to compare synthetic data with experimental data and output denoised data similar to the experimental data from synthetic data. According to an embodiment, the first learning unit 125-1 may store the trained denoising model in the memory 120.

According to an embodiment, the second learning unit 125-2 may train an extraction model extracting noise data reflecting the noise characteristics of the field data, based on experimental data and field data. The extraction model may be a machine learning-based learning model trained to compare experimental data and field data, recognize the characteristics of noise in the field data, and extract noise data reflecting these characteristics from the field data. According to an embodiment, the second learning unit 125-2 may store the trained extraction model in the memory 120.

According to an embodiment, the filtering unit 127 may generate denoised data by removing (or reducing) noise from synthetic data. According to an embodiment, the filtering unit 127 may generate denoised data by removing (or reducing) noise from synthetic data using the denoising model trained by the first learning unit 125-1 or stored in the memory 120.

According to an embodiment, the third learning unit 125-3 may train a state diagnosis model to diagnose the state of the battery based on input data. The state diagnosis model may be a machine learning-based learning model trained to diagnose the state of the battery (e.g., internal resistance, charge capacity, SOC, SOH, etc.) based on input data.

In an embodiment, the third learning unit 125-3 may generate the first state diagnosis model by training the state diagnosis model based on the denoised data generated by the filtering unit 127. In an embodiment, the third learning unit 125-3 may generate the second state diagnosis model by training the state diagnosis model based on the synthetic data generated by the synthesis unit 220. That is, the third learning unit 125-3 may generate different state diagnosis models by distinguishing between the state diagnosis model trained based on denoised data and the state diagnosis model trained based on synthetic data. The third learning unit 125-3 may store the first state diagnosis model and/or the second state diagnosis model in the memory 120.

In an embodiment, the evaluation unit 129 may evaluate the performance of the denoising model based on the first state diagnosis model and/or second state diagnosis model trained by the third learning unit 125-3. The evaluation unit 129 may evaluate the performance of the denoising model by comparing the first state diagnosis model trained based on data obtained by removing (or reducing) noise from synthetic data and the second state diagnosis model trained based on synthetic data from which noise has not been removed (or reduced). Here, the performance of the denoising model may be related to how precisely noise has been removed (or reduced) from the synthetic data. For example, the evaluation unit 129 may evaluate the performance of the denoising model by considering the level of performance improvement of the first state diagnosis model compared to the second state diagnosis model. The evaluation unit 129 may use a variety of methods related to machine learning model evaluation to compare the first state diagnosis model and the second state diagnosis model.

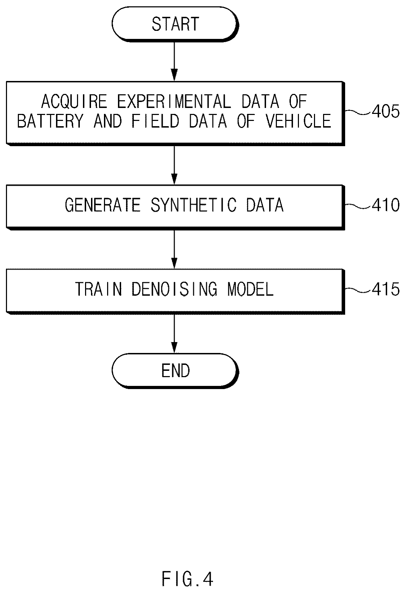

FIG. 4 is a flowchart illustrating operations of a data processing apparatus according to an embodiment. FIG. 4 may illustrate the operations of the data processing apparatus 100 of FIG. 1, and descriptions may be made on the basis of the configuration (e.g., data processing apparatus 100) in FIG. 1.

The embodiment shown in FIG. 4 is merely one embodiment, and the order of steps according to various embodiments of the present invention may be different from that shown in FIG. 4, and some steps shown in FIG. 4 may be omitted, changed in order, or merged.

With reference to FIG. 4, the data processing apparatus 100 may acquire experimental data of the battery and field data of a vehicle (e.g., an electric vehicle equipped with a secondary battery) in operation 405. Here, the experimental data may include data related to the state of the battery not installed in a vehicle. The field data may include data related to the state of the battery installed in the vehicle.

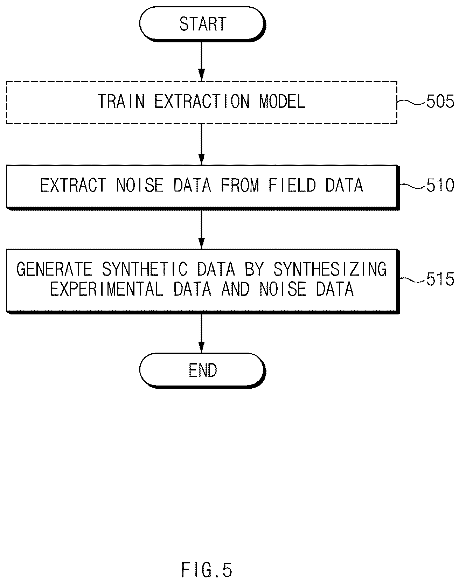

In operation 410, the processing apparatus 100 may generate synthetic data based on the experimental data and field data. The operation 410 in which the data processing apparatus 100 generates synthetic data may be described in more detail with reference to FIG. 5 later.

In operation 415, a denoising model that removes (or reduces) noise from synthetic data may be trained based on experimental data and synthetic data. The denoising learning model may be a machine learning-based learning model trained to compare synthetic data with experimental data and output denoised data similar to the experimental data from synthetic data.

FIG. 5 is a flowchart illustrating operations of a data processing apparatus according to an embodiment. FIG. 5 may illustrate the operations of the data processing apparatus 100 of FIG. 1, descriptions may be made on the basis of the configuration (e.g., data processing apparatus 100) in FIG. 1.

The embodiment shown in FIG. 5 is merely one embodiment, and the order of steps according to various embodiments of the present invention may be different from that shown in FIG. 5, and some steps shown in FIG. 5 may be omitted, changed in order, or merged. For example, operation 505 may be omitted in FIG. 5.

With reference to FIG. 5, the data processing apparatus 100 may train an extraction model extracting noise data reflecting the noise characteristics of the field data, based on experimental data and field data. Here, the experimental data and field data may be data acquired in operation 405 of FIG. 4. The extraction model may be a machine learning-based learning model trained to compare experimental data and field data, recognize the characteristics of noise in the field data, and extract noise data reflecting these characteristics from the field data.

In operation 510, the data processing apparatus 100 may extract noise data from the field data. According to an embodiment, the data processing apparatus 100 may extract noise data from the field data based on an extraction model learned in operation 505 or an extraction model stored in the memory 120. Here, the extraction model may be a machine learning-based model that reflects the noise characteristics of field data to extract noise data.

In operation 515, the data processing apparatus 100 may synthesize experimental data and noise data to generate synthetic data. According to an embodiment, the data processing apparatus 100 may generate the synthetic data by synthesizing random noise (e.g., Gaussian random noise) with the experimental data and noise data.

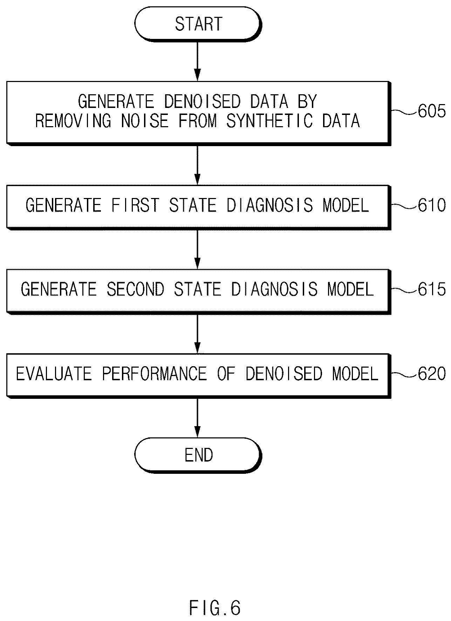

FIG. 6 is a flowchart illustrating operations of a data processing apparatus according to an embodiment. FIG. 6 may illustrate the operations of the data processing apparatus 100 of FIG. 1, and descriptions may be made on the basis of the configuration (e.g., data processing apparatus 100) in FIG. 1.

The embodiment shown in FIG. 6 is merely one embodiment, and the order of steps according to various embodiments of the present invention may be different from that shown in FIG. 6, and some steps shown in FIG. 6 may be omitted, changed in order, or merged.

With reference to FIG. 6, the data processing apparatus 100 may generate denoised data by removing (or reducing) noise from synthetic data. Here, the synthetic data may be the data generated in operation 410 of FIG. 4 or operation 515 of FIG. 5. According to an embodiment, the data processing apparatus 100 may generate denoised data by removing (or reducing) noise from synthetic data using the denoising model trained in operation 415 of FIG. 4 or stored in the memory 120.

In operation 610, the data processing apparatus 100 may generate a first state diagnosis model. According to an embodiment, the data processing apparatus 100 may generate the first state diagnosis model by training the state diagnosis model based on the denoised data generated in operation 605. The state diagnosis model may be a machine learning-based learning model trained to diagnose the state of the battery (e.g., internal resistance, charge capacity, SOC, SOH, etc.) based on input data.

In operation 615, the data processing apparatus 100 may generate a second state diagnosis model. According to an embodiment, the data processing apparatus 100 may generate the second state diagnosis model by training a state diagnosis model that diagnoses the state of a battery based on synthetic data generated in operation 410 of FIG. 4 or operation 515 of FIG. 5.

In operation 620, the data processing apparatus 100 may evaluate the performance of the denoising model learned in operation 415 of FIG. 4 or the denoising model stored in the memory 120. According to an embodiment, the data processing apparatus 100 may evaluate the performance of the denoising model based on the first state diagnosis model trained and generated in operation 610 and the second state diagnosis model trained and generated in operation 615. The data processing apparatus 100 may evaluate the performance of the denoising model by comparing the first state diagnosis model trained based on data obtained by removing (or reducing) noise from synthetic data and the second state diagnosis model trained based on synthetic data from which noise has not been removed. Here, the performance of the denoising model may be related to how precisely noise has been removed from the synthetic data. For example, the data processing apparatus 100 may evaluate the performance of the denoising model by considering the level of performance improvement of the first state diagnosis model compared to the second state diagnosis model. The data processing apparatus 100 may use a variety of methods related to machine learning model evaluation to compare the first state diagnosis model and the second state diagnosis model.

Also, the terms such as "comprise", "include", or "have" used above implies that the corresponding component may be present unless otherwise stated specifically, and thus it should be construed as being able to further include other components rather than exclude other components. Unless otherwise defined herein, all terms including technical or scientific terms used herein have the same meanings as commonly understood by those skilled in the art to which the present invention belongs. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

## Claims

1. A data processing apparatus comprising:
an acquisition unit configured to acquire experimental data of a battery and field data of a vehicle;
a generation unit configured to generate synthetic data based on the experimental data and the field data; and
a first learning unit configured to train a denoising model to remove noise from the synthetic data based on the experimental data and the synthetic data.

2. The data processing apparatus of claim 1, wherein the generation unit comprises an extraction unit configured to extract noise data from the field data and generate the synthetic data by synthesizing the experimental data and the noise data.

3. The data processing apparatus of claim 2, further comprising a second learning unit configured to train an extraction model extracting the noise data reflecting noise characteristics of the field data based on the experimental data and the field data,
wherein the extraction unit is configured to extract the noise data from the field data based on the extraction model.

4. The data processing apparatus of claim 1, further comprising a filtering unit configured to generate denoised data by removing noise from the synthetic data using the denoising model.

5. The data processing apparatus of claim 4, further comprising a third learning unit configured to generate a first state diagnosis model by training a state diagnosis model diagnosing state of the battery based on the denoised data.

6. The data processing apparatus of claim 5, wherein the third learning unit is configured to generate a second state diagnosis model by training the state diagnosis model based on the synthetic data.

7. The data processing apparatus of claim 6, further comprising an evaluation unit configured to evaluate the performance of the denoising model by comparing the first state diagnosis model and the second state diagnosis model.

8. A data processing method comprising:
acquiring experimental data of a battery and field data of a vehicle;
generating synthetic data based on the experimental data and the field data; and
training a denoising model to remove noise from the synthetic data based on the experimental data and the synthetic data.

9. The data processing method of claim 8, wherein the generating of the synthetic data comprises:
extracting noise data from the field data; and
generating the synthetic data by synthesizing the experimental data and the noise data.

10. The data processing method of claim 9, further comprising training an extraction model extracting the noise data reflecting noise characteristics of the field data based on the experimental data and the field data,
wherein the noise data is extracted from the field data based on the extraction model.

11. The data processing method of claim 8, further comprising generating denoised data by removing noise from the synthetic data using the denoising model.

12. The data processing method of claim 11, further comprising generating a first state diagnosis model by training a state diagnosis model diagnosing state of the battery based on the denoised data.

13. The data processing method of claim 12, further comprising generating a second state diagnosis model by training the state diagnosis model based on the synthetic data.

14. The data processing method of claim 13, further comprising evaluating the performance of the denoising model by comparing the first state diagnosis model and the second state diagnosis model.
